# EUROPEAN PATENT APPLICATION

(11) **EP 4 737 295 A1**
(43) Date of publication of application: **06.05.2026**
(21) Application number: 24020326.5
(22) Date of filing: 04.11.2024
(51) Int. Cl.: B63B 3/68, B63J 3/04, F24S 20/66, H10N 10/10, H10N 10/80

(54) **THERMOELECTRIC SYNTHETIC DECKING FOR MARINE VESSELS**

(71) Applicant: Curcio, Mario, 6280 Hochdorf (CH)
(72) Inventor: Curcio, Mario, 6280 Hochdorf (CH)

(57) **Abstract**

The present disclosure refers to a synthetic decking for marine vessel decks comprising at least one decking panel comprising at least two adjacent strips imitating planks separated by caulking or planks directly adjacent to each other, the adjacent strips alternately having respectively different thermal absorption properties such that strips with a relatively lower thermal absorption property alternate to strips with a relatively higher thermal absorption property, thereby resulting in a temperature difference between adjacent strips when exposed to solar radiation, the decking panel further comprising at least one integrated thermopile comprising a series of thermocouples having junctions alternately arranged in thermal contact with either of the at least two adjacent strips such as to generate an output voltage and an electric current based on the thermoelectric Seebeck effect caused by the temperature difference between the adjacent strips. A method of manufacturing the synthetic decking is herein also disclosed.

## Description

### Field of the invention

The present invention is in the field of renewable energy sources for marine vessels, including the manufacturing and use of synthetic decking materials also for this purpose.

### Background

Marine vessels rely on battery power storage for onboard instrumentation and electric appliances. Sufficient electrical power availability at all times and for all needs can be a challenge, especially for high-power demanding uses like air conditioning, heating and the like, typically requiring intense use of a combustion-based generator. Thus, more and more often marine vessels comprise one or more renewable energy sources, such as solar panels, wind turbines and hydro-generators contributing to some extent to battery recharging and sustainable onboard living. In particular, there is a trend also in the yachting industry, like in the automobile industry, towards more ecological and sustainable solutions, which are based on the gradual replacement of combustion engines with electric motors and of fuel tanks with battery packs, thus using stored battery power also for propulsion, and almost exclusively renewable energy sources for recharging the batteries. Thus, the need for more power storage, for more energy sources, for faster and more efficient recharging, and for more efficient power management is higher and higher.

Some marine vessels, especially multi-hull marine vessels with a larger beam to length ratio, such as catamarans, can offer sufficient surface for installing solar panels with sufficient power output for autonomous battery recharging. Current designs manage to achieve a power output of e.g. up to 20 Kwp on a 60-feet catamaran and up to 30 Kwp on a 80-feet catamaran, with solar panels alone, which can provide unlimited cruising range at certain vessel speeds, e.g. of about 6-8 Knots, at least in summer time and sunny days. A combustion-based generator is typically provided as a backup solution for battery recharging in case of prolonged cast sky over several days or when increased speed is required over a prolonged time or during winter time and/or long night passages.

Wind turbines may contribute to meet the power demand, at least in sufficiently windy conditions, when solar energy is not available or insufficient. However, wind turbines, do not typically bring a significant advantage on solar yachts, as they require additional space, they introduce injury risks and noise, and can possibly reduce the efficiency of the solar panels by casting a shadow on them.

Hydro-generators can also be installed as renewable energy source on a vessel. The efficiency of a typical hydro-generator is however also comparatively low with respect to solar energy. The power output of a typical hydro-generator is e.g. about comparable to the power output of a single solar panel or less, e.g. in the range of a hundred to a few hundred W depending on size and vessel speed, for vessel speeds typically starting at 5 Knots at least, although contrary to wind and solar, which are not always available, as long as the vessel is sailing and maintaining a minimum speed, a hydro-generator can provide a stable and continuous output, e.g. also during night passages. A hydro-generator is usually fastened on the transom of a vessel, attached to a lifting bracket, or fixedly under the hull of the vessel with power connection through the hull. The performance depends on the position and the quality of water flow in that position. It should therefore be placed as far as possible from the wake of appendages, such as rudders, sail drives and keel. In general, the greater the depth, the farther the propeller will be from the wake of the hull, and the better the performance of the hydro-generator. However, the longer the lever arm is, the greater the force on the mountings and during lifting will be for the version fastened to the transom. Also, the greater the depth the greater the drag force will be, affecting vessel speed. Also, the power generated depends on the size of the propeller and on the vessel speed, the bigger the propeller and the greater the vessel speed, the greater the power output. However, with increasing propeller size and vessel speed also the drag increases, causing a loss of vessel speed. The version fastened to the transom allows easier maintenance but is bulky and can be esthetically unpleasant, especially when lifted. The system is not designed to replace the engine's alternator, in case of combustion engines. It can nevertheless be used while operating the engine. However, electrical output can be significantly disrupted depending on the location of the hydro-generator and the water turbulence caused by the engine. The hydro-generator, in the version fastened to the transom, must be lifted when reversing the vessel in order to avoid any possible damage to the leg and cradle mountings. Hydro-generators in their typical designs and operating mode, are thus typically useful, at least to some extent, only for some cruising vessels, typically sailing vessels, with limited solar energy capacity, which are mainly propulsed by wind, on long passages.

It is therefore clear that additional or alternative ways of renewably generating energy on a marine vessel are still needed.

Undoubtedly, solar energy remains the most important renewable energy source available to marine vessels. Utilization of solar energy can be classified as solar photovoltaic and solar thermal. The solar photovoltaic (PV) converts photon energy directly into electricity by means of photovoltaic cells, herein interchangeably referred to also as solar panels. The solar thermal, converts photon energy into heat, that is typically stored in a medium, typically a fluid, typically through an optical concentrator, and typically uses mechanical heat engines to generate electricity. Photovoltaic cells (solar panels) can be used on rooftops as well as marine vessel tops, while the solar-thermal energy conversion by mechanical heat engines is suitable only for large-scale power generation applications.

The prospect of using thermoelectric devices on a smaller scale that rely on the Seebeck effect in solid materials to convert thermal energy into electricity has been pursued in some fields as well, such as e.g. disclosed in US 11723274B2, by placing thermoelectric modules underneath bituminous roof shingles (suitable only for roof tops), but it has not been widely utilized because of the low efficiency of thermoelectric devices, that is even lower than that of photovoltaic cells. It does not make therefore much sense to utilize thermoelectric devices on rooftops or marine vessel tops instead of photovoltaic cells.

The tendency has been therefore to extend the application of photovoltaic cells to other surfaces of the marine vessels, other than marine vessel tops, possibly exposed to solar radiation, such as on curved edge surfaces or even on the hull sides, or on the mast of a sailing marine vessel, by using flexible solar panels directly glued on such surfaces, although their efficiency is in general lower than standard solar panels and even lower at these positions, e.g. because the radiation angle is not ideal, not all sides are exposed to the sun at the same time and they are more subject to get dirty during navigation, e.g. by salt depositions, or covered by objects such as lines, fenders and the like. Also, the risk of being damaged is higher.

Although some flexible solar panels can be carefully walked on, at least occasionally, they are not suitable for decking regularly walkable surfaces such as marine vessel decks. They can otherwise be easily scratched, cracked, or deformed just by walking on them or by accidental falling of objects. Also, they are typically more slippery than regular deck surfaces, especially when wet, and would reduce safety onboard.

Marine vessel decks can be made of different structural materials, including e.g. wood or fiberglass and/or carbon fiber embedded in a resin, typically comprising an external gelcoat layer, metals such as aluminum or steel, etc. Traditionally, if the deck surface of a marine vessel was to be covered, this was done by applying a teak decking. Cork is another naturally occurring material that has been more rarely used as alternative to teak, but which is esthetically less attractive. A more recent trend is to cover deck surfaces with synthetic decking, i.e. synthetic materials are used instead of teak that esthetically imitate natural teak decking.

An example of synthetic decking, i.e. a decking made of a synthetic material, is a PVC (polyvinyl chloride) synthetic decking comprising a filler such as chalk. Teak decking and such synthetic decking have different properties. One significant difference is that teak decking needs regular maintenance to a larger extent if the new look of the decking is to be maintained. A synthetic decking has many advantages over traditional teak decking. In particular, a PVC-based decking is long lasting, with minimal maintenance compared to natural teak, and designed to cope in all weather conditions. It is lighter in weight, easier to manufacture and to install and has a lower environmental impact. However, when it is exposed to solar radiation it can be heated up and retain the heat to a larger extent than traditional teak decking. Newer synthetic decking materials available on the market have reduced this problem, e.g. by incorporation of hollow microballoons as disclosed in US9676925B2. Despite that, a synthetic decking, depending on the particular composition and other features such as color, can reach temperatures of e.g. up to about 50-70 °C under peaks of solar radiation. Cheaper synthetic decking materials based on polymers other than PVC, such as a copolymer of ethylene and vinyl acetate, also called EVA foam, can get less hot, but are significantly less durable.

### General description

In view of the above background, applicant has realized that synthetic decking materials which are commonly used on marine vessels for decking marine vessel decks, can be actually modified such as to become an additional energy source by converting the absorbed solar-thermal energy into electricity and thereby turning a typical disadvantage (their characteristic of heating up under solar radiation) into an advantage. In particular, a new thermoelectric synthetic decking is herein disclosed comprising at least one decking panel comprising at least two adjacent strips imitating planks separated by caulking or planks directly adjacent to each other, the adjacent strips alternately having respectively different thermal absorption properties such that strips with a relatively lower thermal absorption property alternate to strips with a relatively higher thermal absorption property, thereby resulting in a temperature difference between adjacent strips when the decking panel is exposed to solar radiation, the decking panel further comprising at least one integrated thermopile comprising a series of thermocouples having junctions alternately arranged in thermal contact with either of the at least two adjacent strips such as to generate an output voltage and an electric current based on the thermoelectric Seebeck effect caused by the temperature difference between the adjacent strips.

The advantage of such a solution is that despite the comparatively lower efficiency per surface area of such a thermoelectric device with respect to photovoltaic cells, it can be used where photovoltaic cells cannot typically be used, in particular on regularly walkable marine vessel decks. It is thus not intended to replace solar panels which are rather installed on a marine vessel top, but as an addition to the solar panels installed on the marine vessel top or as an alternative to solar panels when insufficient marine vessel top surface is available, e.g. on most mono-hull marine vessels, whereas walkable deck surface exposed to solar radiation is mostly available.

These and other advantages will become apparent from the following description.

Of course, the thermoelectric synthetic decking of the present disclosure may be applicable to any other outdoor surface other than marine vessel decks and beyond the marine industry, including any surface where synthetic decking is also applicable, including in the building and urban construction industry, such as outdoor pavements and terraces. It is however most suitable for decking marine vessel decks. On the contrary, not any other decking material, e.g. roofing material such as the roof shingles disclosed in US 1 1723274B2, is suitable for decking walkable marine vessel decks, both esthetically and functionally.

The term "synthetic decking" refers to a thin and flexible decking material made using a synthetic polymer as main component and typically any one or more other components such as fillers, plasticizers, stabilizers, colorant pigments and other additives, and possibly even natural fibers, e.g. wood fibers. The term synthetic decking thus includes also composite decking. The most commonly used synthetic polymer is PVC, typically provided as virgin polymer pellets. Other UV-stable and durable polymer materials can be used as well. EVA foam is less suitable for the purpose of the present disclosure due to its lower durability, lower thermal absorption properties, softness, and increased susceptibility to damage. According to a preferred embodiment, the synthetic decking is PVC-based.

The synthetic polymer can be mixed with any other component as mentioned above and is typically subjected to an extrusion process in order to obtain an extruded flexible conforming decking panel, typically having a thickness below one centimeter, e.g. about 5-6 millimeters, and with a surface area that can be custom dimensioned, e.g. based on a template, such as to precisely cover and fit any walkable surface of a marine vessel deck. Extrusion dies control the dimensions and shape of the decking panel, which is then cooled typically in a temperature-controlled water bath. The final custom shape of a single panel can be obtained by cutting and shaping the edges of a decking panel of regular shape and/or joining decking panels together, e.g. by welding or gluing. Using vinyl welding techniques makes the joints stronger and more durable than using glue. The surface of the decking panel can still be subject to other processes such as sanding to bring out its grain and texture. It is possible to create any look, from traditional teak to modern designer finishes. Sophisticated extrusion and dosing equipment ensure accuracy, which means that the colors are consistent, and the grain effect is naturally inconsistent, just like real wood. In fact, the synthetic decking is often also referred to as "synthetic teak". In particular, a decking panel typically comprises adjacent strips imitating planks separated by caulking or planks directly adjacent to each other. The adjacent strips can be either extruded jointly together or welded together or a combination of both. Also, the materials of the adjacent strips can be at least partly overlapping. For example, caulking can fill up grooves between planks. One or more decking panels, depending on the deck area to be covered, can be installed, e.g. fixed, to the marine vessel deck or another outdoor area completely assembled, e.g. welded together, in the exact custom size and shape needed based on a template, e.g. as single pieces of up to several meters in width and/or length, or in sections placed together next to each other and sized on location, preferably by means of an adhesive, and can comprise structures or geometries on the lower surface or bottom, such as grooves or the like for facilitating the fixing by the adhesive to the marine vessel deck surface.

The installed synthetic decking won't split, splinter, or crack under normal use. It is UV-resistant, waterproof, it offers good grip in all weather conditions and can last in good conditions for many years, e.g. up to 20 years or more with only minimal maintenance.

In particular, the at least one decking panel of the present disclosure comprises at least two adjacent strips imitating plank and caulking respectively, that is one strip imitating the plank always adjacent and directly in contact with one strip imitating the caulking and so on in repetitive sequence in case of more than two strips, or planks directly adjacent and in contact with each other, where the adjacent strips are joint together, e.g. by means of a joint extrusion process or welding, e.g. vinyl welding. The welding material itself that can be used between two strips imitating the planks can replace the strip imitating the caulking like actual caulking. Importantly, the adjacent strips alternately have respectively different thermal absorption properties such that strips with a relatively lower thermal absorption property alternate to strips with a relatively higher thermal absorption property, e.g. the strips imitating the planks have a thermal absorption property lower than the strips imitating the caulking, thereby resulting in a temperature difference between adjacent strips, e.g. between the strips imitating the planks and the strips imitating the caulking, under the same conditions of exposure to solar radiation. Analogously, if only strips imitating planks directly adjacent to each other (without caulking) are used, they should have alternately different thermal absorption properties, that is one higher and one lower, and so on in repetitive sequence if the decking panel comprises more than two strips. It is advantageous if the temperature difference is as large as possible and therefore if the difference in the thermal absorption property between the adjacent strips is as large as possible.

According to an embodiment, the alternating adjacent strips have a respectively different color, the color being substantially responsible for the respectively different thermal absorption property. For example, in order to have a lower thermal absorption property, lighter and more reflective colors, e.g. white or lighter gray can be used, whereas higher thermal absorption properties can be obtained by darker colors such as black or darker gray, as it is known that darker colors are more heat absorptive and lighter colors are more heat reflective when exposed to solar radiation. Different colors for the adjacent strips can be obtained for example by adding respectively different colorant pigments to the synthetic material compositions or using a different color for the welding material making up the caulking.

In addition or in alternative to different respective colors for the adjacent strips, different compositions of the synthetic material can be used as well, e.g. by adding hollow microspheres or microballoons as disclosed e.g. in US9676925B2 only to the material composition used to make the strips with the lower thermal absorption property, and/or by adding heat reflective fillers to the material composition used to make the strips with the lower thermal absorption property and/or by adding heat absorptive fillers to the material composition used to make the strips with the higher thermal absorption property respectively.

Fillers can be any suitably sized particles of naturally occurring materials such as chalk, talc, granite, silica sand, quartz, marine shells and the like, that can be used as such or additionally treated, e.g. coated, colored and the like, in order to enhance their heat reflective or absorptive property.

"Heat reflective," means having enhanced reflectance in the near infrared range. "Heat absorptive" means having diminished reflectance in the near infrared range. When referring to a decking panel strip, "heat reflective" means having a greater solar heat reflectance than a heat absorptive strip and vice versa, "heat absorptive" means having a lower solar heat reflectance than a heat reflective strip. They are to be used therefore as relative terms and not absolute terms. The difference in thermal absorption property or solar heat reflectance is such that as a result, temperatures differences of e.g. at least about 10°C and preferably more, e.g. 20-30 °C or more (under peaks of solar radiation) between adjacent strips can be obtained, by one or a combination of the above methods.

According to an embodiment, the strips with the relatively higher thermal absorption property have a width smaller than the strips with the relatively lower thermal absorption property. This is achieved e.g. by having the strips imitating the planks with a width typically in the order of a few centimeters and the strips imitating the caulking or the caulking itself with a width typically in the order of a few millimeters.

According to an embodiment, the strips with the relatively higher thermal absorption property are arranged sufficiently deeper than the strips with the relatively lower thermal absorption property such as to avoid contact with the deeper strips upon walking on the synthetic decking. This is especially advantageous when walking bare foot such as to prevent possible discomfort or even injures caused by heat as the feet remain in contact only with the strips having the relatively lower thermal absorption property and hence lower surface temperature under the same conditions of solar radiation, the combination of smaller width and lower depth for the strips with the relatively higher thermal absorption property being most effective.

The term "deeper" is thus to be interpreted with respect to the upper or top surface of the decking panel (exposed to solar radiation), implying that the thickness of the deeper strips is smaller than the thickness of the adjacent strips, e.g. about 1-3 millimeters smaller or about 1-3 millimeters deeper, depending on the overall thickness of the decking panel.

The decking panel of the present disclosure further comprises at least one integrated thermopile comprising a series of thermocouples having junctions alternately arranged in thermal contact with either of the at least two adjacent strips such as to generate an output voltage and an electric current based on the thermoelectric Seebeck effect caused by the temperature difference between the adjacent strips.

A thermopile is an electronic device that converts thermal energy into electrical energy. It is composed of several thermocouples connected electrically in series and thermally in parallel, i.e. zigzagging back and forth between higher temperature and lower temperature. A thermocouple comprises two thermolegs made respectively of dissimilar electrically conducting materials, typically metals or alloys, one thermoleg being n-type and the other p-type material. When a heat flux passes through a thermocouple from one p/n junction to another, a voltage and current is generated based on the Seebeck effect. The total output voltage of a thermopile is equal to the sum of the output voltages of each thermocouple, the greater the temperature differential, the greater the output voltage. These voltages are in general very small, typically in the order of a few millivolts per thermocouple. This implies that it takes a thousand of thermocouples in series to output a voltage in the order of a few Volts. It is therefore apparent that a great number of thermocouples with a high aspect-ratio in high-density arrays is required if thermoelectricity is to be used for small-scale energy generation. Also, the greatest possible temperature differential is required, besides a proper choice of materials for the thermocouples with a sufficiently high Seebeck coefficient (ratio between the voltage difference induced and the temperature difference). Moreover, it is important that the manufacturing process is simple and inexpensive.

Conventional three-dimensional thermopile designs, where the junctions of a thermopile alternate between opposite sides of a substrate (upper and lower side) with different respective temperatures, are typically limited to low-aspect-ratio elements due to manufacturing limitations. Moreover, the techniques used for manufacturing these three-dimensional designs are not scalable and cost-effective.

According to the present disclosure, planar (in-plane) designs, where the junctions of the thermocouples alternate between zones with different respective temperatures on the same side of a substrate, and techniques which enable high-density thermopiles, i.e. up to several hundreds of thermocouples per linear meter or even more, e.g. up to a few thousands thermocouples per linear meter, to be fabricated on an electrically insulating substrate, particularly on a flexible substrate, are most suitable and well-fitting to the design of a thin synthetic decking comprising adjacent strips that can differently absorb solar thermal energy.

In particular, various printing techniques may be suitably used for printing the thermopile, e.g. by dispenser or inkjet printing or screen printing or any other suitable printing technique using respectively inks, screen printable pastes or mixes comprising thermoelectric materials mixed with a suitable binder and/or solvent.

For example, printed thick-film deposition techniques are well suited for fabrication of flexible planar thermoelectric devices. Printing involves the deposition of thermoelectric inks that are synthesized by mixing active materials in polymer binders and solvents. In particular, dispenser and inkjet printing technologies have been introduced to realise thermocouples on a flexible polyimide film (Kapton^{™}). For a detailed description of materials and methods reference is made to other publications such as: A Chen et al 2011 J. Micromech. Microeng. 21 104006.

Screen printing is another simple and low-cost process that is well suited for large area fabrication of thermoelectric devices. It involves the use of screen printable pastes similar to the above-mentioned inks comprising thermoelectric material powders in a binder and solvent matrix, e.g. Bi₂Te₃ and Sb₂Te₃ alloy powders and an epoxy binder. A solvent is added to the paste to adjust the viscosity to a screen printable level. After printing, only a curing process is required. For a detailed description of materials and methods reference is made to other publications such as: Zhuo Cao et al, Journal of Physics: Conference Series 476 (2013) 012031.

US4276441 discloses yet another suitable method using powdered metals, e.g. copper, chromel, constantan, finely divided and mixed with a proper binder or flux to form a metallic ink, to print a multiplicity of thermocouples in series on a suitable substrate, e.g. 100 per linear inch. This printing may be done via a silk screen method or by offset, lithographic or letterpress printing processes. Sheets of substrate are sequentially fed through first and second metallic ink printers and the thermolegs are printed in a sequential manner, e.g. copper or chromel may go on first and then constantan goes second. They are then passed through an induction furnace where the metals are melted. A microwave oven or a laser-controlled fuser may be employed instead of the induction furnace. Thermocouples are formed by an intermingling of the metals at the junctions.

According to an embodiment, the decking panel is made as a single layer and the thermopile is printed directly on a bottom side of the single layer using e.g. any fabrication technique as mentioned above, eventually adapting some of the method steps, e.g. the curing steps, in order to take into account the range of temperature that the synthetic material can be exposed to.

According to an embodiment, the decking panel is made as a multilayer comprising at least a top layer and a bottom layer, where the bottom layer is made of the same or different material(s) of the top layer, and where the thermopile is printed directly either on a bottom side of the top layer or on a top side of the bottom layer using e.g. any fabrication technique as mentioned above, eventually adapting some of the method steps, e.g. the curing steps, in order to take into account the range of temperature that the synthetic material can be exposed to, followed by alignment and joining of the top layer and the bottom layer, e.g. by adhesive or welding, such that the thermopile is embedded at least partly in the inside of the decking panel.

According to an embodiment, the thermopile is printed on an intermediate layer of the same or different material of the top layer and/or the bottom layer using e.g. any fabrication technique as mentioned above, and then sandwiched between the top layer and the bottom layer comprising alignment and joining e.g. by adhesive or welding, of all layers.

Different materials for the bottom layer or the intermediate layer may include flexible thin substrates such as polyimide films like Kapton^{™} used in flexible printed circuits, that are electrically insulating and stable across a wide range of temperatures.

Using a different material has the advantage of making the thermopile printing process independent of the characteristics of the synthetic material of the decking panel such as resistance to curing temperatures and the like. Also, strips with a surface area smaller than the entire decking panel can be used for printing the thermopiles, therefore facilitating the printing process, followed by alignment and fixing of the printed strips to the corresponding areas of the decking panel.

The term "integrated" thus refers to the thermopile becoming integral part of the decking panel, thermally in contact with the upper surface of the decking panel exposed to solar radiation through heat distribution though the thickness of the decking panel or of the top layer but eventually invisible from the upper surface, so that an installed thermoelectric synthetic decking according to the present disclosure can be optically indistinguishable from a regular synthetic decking. This enables the continued use and function of current designs of synthetic decking for marine vessel decks, that can be regularly walked on, while additionally enabling energy production, the thermopile being protected in the inside or below from any possible damage and position shift.

A decking panel may comprise one thermopile for each pair of adjacent strips, if the decking panel comprises several strips, that may be electrically interconnected in parallel or in series to make a larger thermopile. The decking panel may further comprise electrical connectors or terminals for connecting the at least one thermopile of the decking panel to at least another thermopile of another decking panel and/or to an electric circuit connected to an electrical energy receiving and/or storage unit of the marine vessel.

The present disclosure is also directed to a marine vessel comprising a thermoelectric synthetic decking as herein described and an electrical energy receiving and/or storage unit connected to the thermoelectric synthetic decking via an electric circuit.

A "marine vessel" according to the present disclosure is a vessel such as a boat, a yacht, a ship, a ferry or any other floating vessel, either monohull or multihull, adapted for navigation on water, such as ocean, sea, lake, river, regardless of its use, e.g. as a leisure vessel, or for commercial or dedicated use, e.g. as a charter yacht, a fishing boat, a ferry for transportation of people and/or other vehicles, a ship for transportation of goods, etc...

The present disclosure refers also to a method of manufacturing a synthetic decking for marine vessel decks. The method comprises manufacturing at least one decking panel comprising extruding jointly at least two adjacent strips and/or welding together at least two extruded adjacent strips imitating planks separated by caulking or planks directly adjacent to each other, and comprises using alternately different extrudable material compositions for the adjacent strips having respectively different thermal absorption properties such that strips with a relatively lower thermal absorption property alternate to strips with a relatively higher thermal absorption property, thereby resulting in a temperature difference between adjacent strips when the decking panel is exposed to solar radiation.

The method further comprises integrating at least one thermopile into the decking panel comprising a series of thermocouples having junctions alternately arranged in thermal contact with either of the at least two adjacent strips such as to generate an output voltage and an electric current based on the thermoelectric Seebeck effect caused by the temperature difference between the adjacent strips.

According to an embodiment, the method comprises using material compositions for the adjacent strips having respectively different colors, the color being substantially responsible for the respectively different thermal absorption property, and/or using a material composition for the strips with the relatively lower thermal absorption property comprising hollow microspheres and/or heat reflective fillers and/or using a material composition for the strips with the relatively higher thermal absorption property comprising heat absorptive fillers.

According to an embodiment, the method comprises manufacturing the strips with the relatively higher thermal absorption property with a width smaller than the strips with the relatively lower thermal absorption property and/or arranging the strips with the relatively higher thermal absorption property sufficiently deeper than the strips with the relatively lower thermal absorption property such as to avoid contact with the deeper strips upon walking on the synthetic decking.

According to an embodiment, integrating the at least one thermopile into the decking panel comprises manufacturing the decking panel as a single layer and printing the thermopile directly on a bottom side of the single layer or manufacturing the decking panel as a multilayer comprising at least a top layer and a bottom layer, wherein the bottom layer is made of the same or different material(s) of the top layer, and printing the thermopile directly either on a bottom side of the top layer or on a top side of the bottom layer or on an intermediate layer of the same or different material of the top layer and/or bottom layer and then sandwiching the intermediate layer between the top layer and the bottom layer comprising aligning and joining all layers thereby embedding the thermopile at least partly in the inside of the decking panel between the bottom layer and the top layer.

According to an embodiment, the method comprises printing the thermopile by dispenser or inkjet printing or screen printing or any other suitable printing technique using respectively inks, screen printable pastes or mixes comprising thermoelectric materials mixed with a suitable binder and/or solvent.

According to an embodiment, the method comprises adding electrical connectors or terminals to the decking panel for connecting the at least one thermopile of the decking panel to at least another thermopile of another decking panel and/or to an electric circuit connected to an electrical energy receiving and/or storage unit.

Other and further objects, features and advantages will appear from the following description of exemplary embodiments and accompanying drawings, which serve to explain the principles more in detail.

### Brief description of the drawings

FIG. 1 shows schematically a marine vessel comprising a thermoelectric synthetic decking and an energy storage unit connected to the thermoelectric synthetic decking via an electric circuit.
FIG. 2 shows schematically further aspects of the synthetic decking of FIG. 1.
FIG. 3 shows schematically a variant of the embodiment of FIG. 2, where the adjacent strips imitate planks directly adjacent to each other.
FIG. 4 shows an alternative higher-density thermopile layout compared to the layout of FIG. 2 and similar to that of FIG. 3.
FIG. 5A shows schematically a decking panel area comprising a plurality of thermopiles connected in series.
FIG. 5B shows schematically an alternative layout compared to that of FIG. 5A, where the thermopiles are connected in parallel.
FIG. 6 shows schematically an exploded perspective view of a small section of a multilayered decking panel comprising a top layer and a bottom layer, where the thermopile is printed directly on a top side of the bottom layer.
FIG. 7 shows schematically an exploded perspective view of a small section of a multilayered decking panel comprising a top layer, a bottom layer and a flexible polyimide film as intermediate layer between the top layer and the bottom layer, where the thermopile is printed directly on the intermediate layer.
FIG. 8A shows schematically a cross section of a multilayered decking panel like that shown in FIG. 6.
FIG. 8B shows schematically a cross section of a multilayered decking panel like that shown in FIG.7.
FIG. 8C shows schematically a cross section of a multilayered decking panel according to a different embodiment.
FIG. 8D shows schematically yet another embodiment of multilayered decking panel.
FIG. 8E shows schematically yet another embodiment of multilayered decking panel.
FIG. 8F shows schematically yet another embodiment where the decking panel is made as a single layer and the thermopile is printed directly on a bottom side of the single layer.
FIG. 9 shows schematically a possible layout of a strip made out of a flexible polyimide film as intermediate layer or bottom layer of a multilayered decking panel with a thermopile printed thereon.
FIG. 10A shows schematically different possible ways that can be used in combination, for increasing the difference in thermal absorption properties between adjacent strips.
FIG. 10B shows schematically yet an additional way that can be used in combination with those already shown in FIG. 10A, for further increasing the difference in thermal absorption properties between adjacent strips.

Skilled artisans appreciate that elements in the figures are illustrated for simplicity and clarity and have not necessarily been drawn to scale. For example, the dimensions of some of the elements in the figures may be exaggerated relative to other elements whereas other elements may have been left out or represented in a reduced number in order to enhance clarity and improve understanding of the embodiments of the present disclosure.

### Detailed description

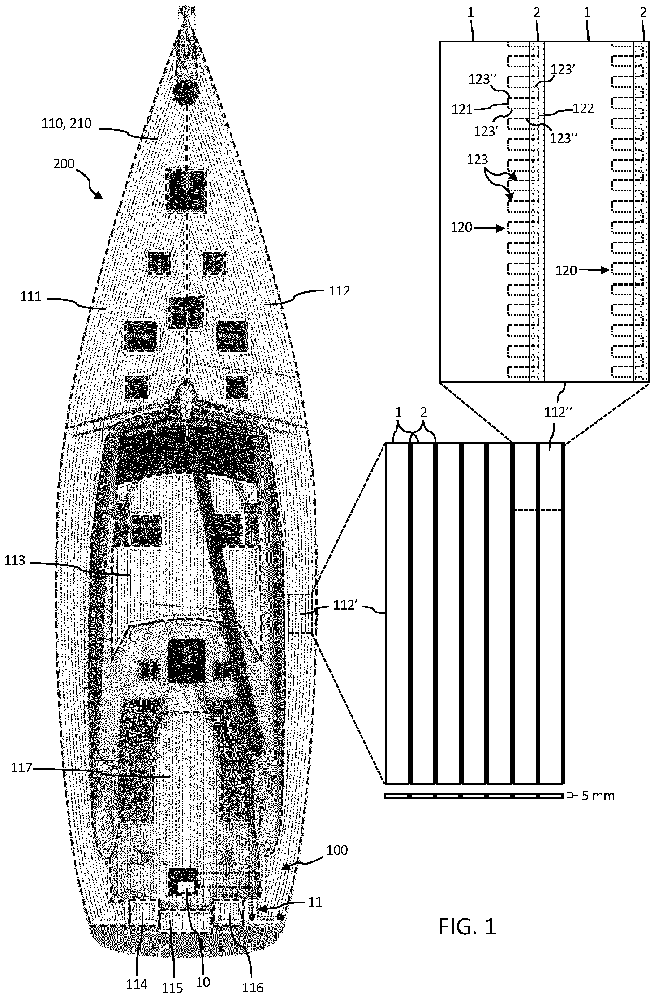

FIG. 1 shows schematically a marine vessel 200 comprising a synthetic decking 110 installed on the marine vessel deck 210 comprising a plurality of decking panels 111, 112, 113, 114, 115, 116, 117, the borders of which are demarcated with a dashed line, each having a surface area that is custom dimensioned, e.g. based on a template, such as to precisely cover and fit a respective surface area of the marine vessel deck 210. This is only an example, and any other layout could be envisaged. In particular, only part of the synthetic decking 110, e.g. the part comprising the largest decking panels and/or the decking panels which are most exposed to solar radiation, e.g. decking panels 111, 112, 113 may be embodied as thermoelectric synthetic decking 100. The thermoelectric decking panels 111, 112, 113 can be optically indistinguishable from the regular decking panels 114, 115, 116, 117. The marine vessel 200 further comprises an electrical energy storage unit 10, e.g. a battery bank, connected to the thermoelectric synthetic decking 100 comprising decking panels 111, 112, 113, via an electric circuit 11.

FIG. 1 schematically also shows a magnified section 112' of the thermoelectric decking panel 112, comprising a plurality of adjacent strips 1, 2 imitating planks 1 separated by caulking 2, the adjacent strips 1, 2 alternately having respectively different thermal absorption properties such that strips 1 with a relatively lower thermal absorption property alternate to strips 2 with a relatively higher thermal absorption property, thereby resulting in a temperature difference between adjacent strips 1, 2 when the decking panel 112 is exposed to solar radiation. The overall thickness of the decking panel 112, 112' is in this example of about 5 millimeters. The adjacent strips 1, 2 can either be extruded jointly together or welded together or a combination of both, as monolayers or multi-layers.

FIG. 1 also shows a magnified section 112" of the magnified section 112' of the thermoelectric decking panel 112, schematically illustrating thermopiles 120 integrated therein comprising a series of thermocouples 123, each thermocouple 123 comprising two thermolegs 123', 123" (represented with two respectively different dashed lines) made of dissimilar thermoelectric materials (p-type and n-type respectively), having p/n junctions 121, 122 alternately arranged in thermal contact with either of the adjacent strips 1, 2 such as to generate an output voltage and an electric current based on the thermoelectric Seebeck effect caused by the temperature difference between the adjacent strips 1, 2. The thermopiles 120 are shown as dashed lines to indicate that they are integrated in the decking panel 112 and are not visible from the outside through the upper surface. Also, the strips 2 with a relatively higher thermal absorption property are shown with a different pattern. The strips with the relatively higher thermal absorption property 2 have a width smaller than the strips 1 with the relatively lower thermal absorption property. A sufficient length of the thermolegs 123', 123" in thermal contact at least with the strips 1 with lower thermal absorption property may be required in order to ensure that a difference in temperature between the junctions 121, 122 is maintained, since lateral heat diffusion and distribution in the near proximity of the border line between strip 1 and strip 2 may partially reduce the temperature differential across the adjacent strips 1, 2.

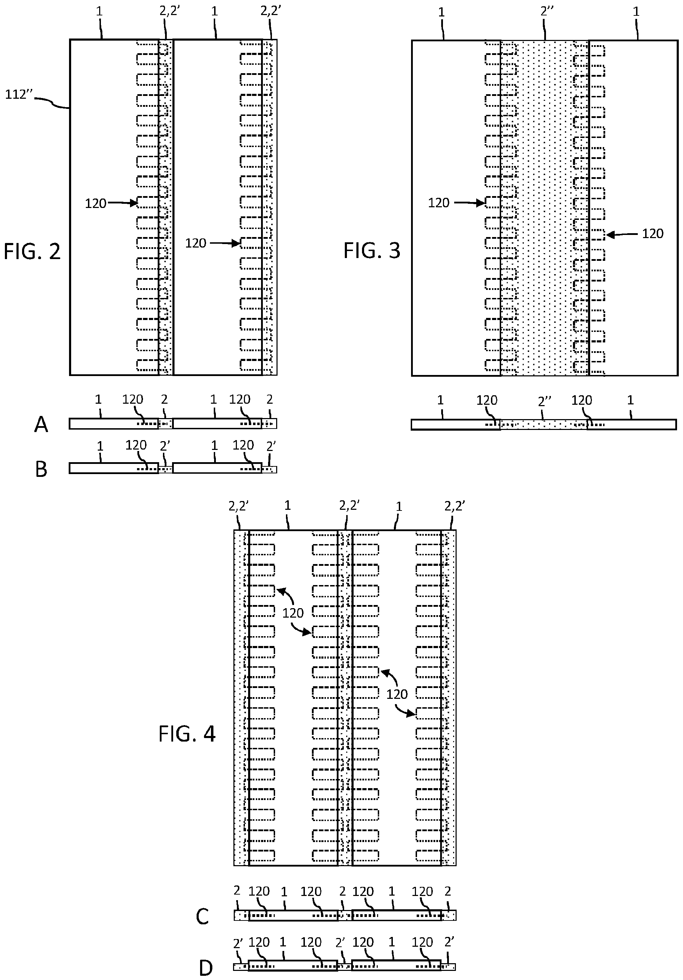

FIG. 2 shows the same magnified section 112" and thermopile layout of FIG. 1 as seen from the top but two alternative embodiments A, B when seen in cross-section from the side. According to embodiment A of FIG. 2, all strips 1, 2 have the same thickness, e.g. about 5 mm. According to embodiment B of FIG. 2, the strips 2' with the relatively higher thermal absorption property are arranged sufficiently deeper, e.g. 1-3 mm deeper, than the strips 1 with the relatively lower thermal absorption property such as to avoid contact with the deeper strips 2' upon walking on the synthetic decking. The strips 2, 2' with the relatively higher thermal absorption property both in the embodiment A and B have otherwise the same width, that is smaller than the width of the strips 1 with the relatively lower thermal absorption property. An additional advantage of the embodiment B is that the thermopiles 120 are closer to the top surface of the deeper strips 2' having relatively higher absorption property and farther from the top surface of the adjacent strips 1 having relatively lower thermal absorption property. Since thermal absorption is highest at the top surface and diminishes through the thickness of the decking panel, this results in a higher temperature differential between adjacent strips 1, 2' compared to the embodiment A with the adjacent strips 1, 2 on the same level.

FIG. 3 shows an alternative embodiment to the embodiments of FIG. 2 where the decking panel comprises adjacent strips 1, 2" imitating planks directly adjacent to each other, the adjacent strips 1, 2" alternately having respectively different thermal absorption properties such that strips 1 with a relatively lower thermal absorption property alternate to strips 2" with a relatively higher thermal absorption property, thereby resulting in a temperature difference between adjacent strips 1, 2" when the decking panel is exposed to solar radiation. This embodiment is thus equivalent to that of FIG. 2, embodiment A, where the strips 2" have the same material composition and thermal absorption property as the strips 2 of FIG. 2 but have the same width besides the same thickness as the strips 1.

FIG. 4 shows an alternative higher-density thermopile layout compared to the layout of FIG. 2 and similar to that of FIG. 3. The alternative embodiments C, D of FIG. 4, are otherwise similar to the alternative embodiments A, B of FIG. 2 respectively, with the exception that the number of thermopiles 120 is double, given the same number of adjacent strips 1, 2, 2'.

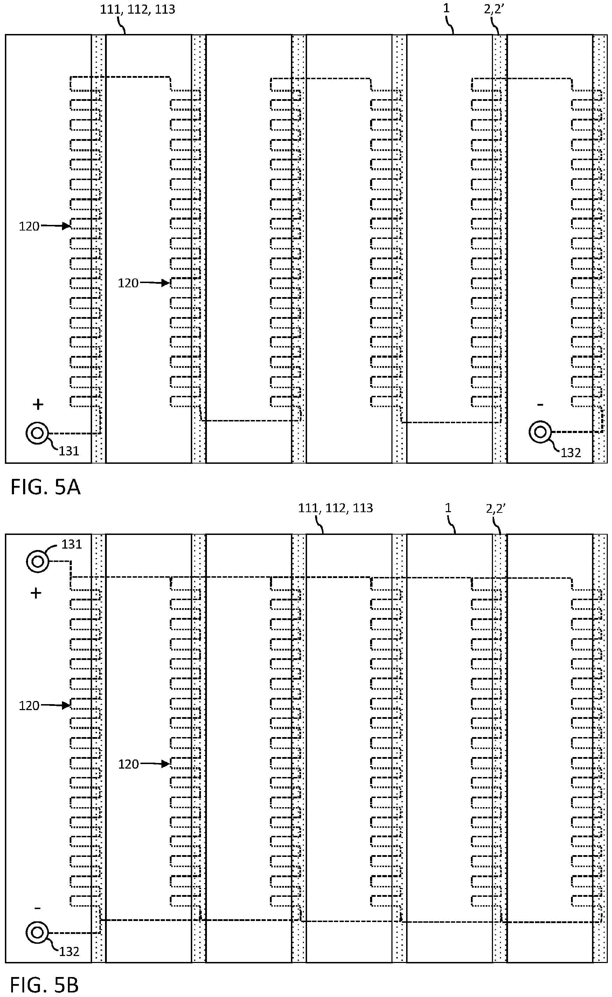

FIG. 5A shows schematically and in much smaller scale a decking panel such as decking panels 111, 112, 113 of FIG. 1 comprising a plurality of adjacent strips 1, 2, 2' and a plurality of thermopiles 120 connected in series. The decking panel 111, 112, 113 further comprises electrical connectors or terminals 131, 132 for connecting the thermopile(s) 120 of one decking panel 111, to the thermopile(s) 120 of another decking panel 112, 113 and/or to the electric circuit 11 connected to the electrical energy receiving and/or storage unit 10 (shown in FIG. 1).

FIG. 5B shows still schematically an alternative layout compared to that of FIG. 5A, where the thermopiles 120 are connected in parallel.

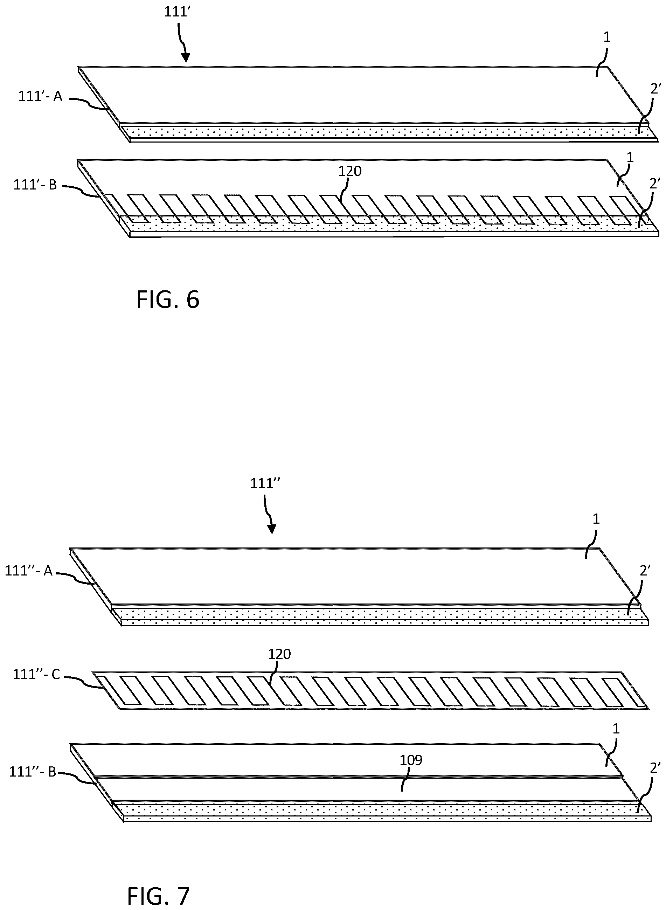

FIG. 6 shows schematically an exploded perspective view of a small section of a multilayered decking panel 111' with a layout similar to that of FIG. 2, embodiment B, where the strip 2' with the relatively higher thermal absorption property is arranged deeper than the strip 1 with the relatively lower thermal absorption property. In particular, the multilayered decking panel 111' comprises a top layer 111'- A and a bottom layer 111'- B, each comprising respectively a top layer and a bottom layer of the adjacent strips 1, 2', and are therefore made of the same respective materials, and where the thermopile 120 is printed directly on the top side of the bottom layer 111'- B in this example. It could be printed on the bottom side of the top layer 111'- A instead. The top layer 111' - A and the bottom layer 111'- B are then aligned and joined together such that the thermopile 120 is embedded in the inside of the decking panel 111' between the top layer 111'- A and the bottom layer 111'- B. The strip 2' with the relatively higher thermal absorption property is arranged deeper than the strip 1 only in the top layer 111'-A.

FIG. 7 shows schematically an exploded perspective view of a small section of a multilayered decking panel 111" that is a variant of the decking panel 111' of FIG. 6, and comprising a top layer 111"- A, a bottom layer 111"- B and a flexible polyimide film 111"- C as intermediate layer between the top layer 111"- A and the bottom layer 111"- B, where the thermopile 120 is printed directly on the intermediate layer 111"- C. Whereas the top layer 111"- A and the bottom layer 111"- B are made of the same respective materials, the intermediate layer 111"-C is in this case therefore made of a different material and then sandwiched between the top layer and the bottom layer comprising alignment and joining of all layers 111"- A, 111"- B, 111"- C such that the thermopile 120 is embedded in the inside of the decking panel 111" between the top layer 111"- A and the bottom layer 111"- B. The bottom layer 111"- B in this example and/or the top layer 111"- A may comprise a recess 109 to accommodate the intermediate layer 111"- C with the thermopile 120 such as to facilitate alignment and to compensate for the additional thickness of the intermediate layer 111"- C. It can be noticed that the surface area of the intermediate layer 111" - C is smaller than the area of decking panel 111" and/or of the top layer 111"- A and bottom layer 111"- B. Also, the thickness of the intermediate layer 111"- C is smaller than the thickness of the top layer 111"- A and bottom layer 111"- B.

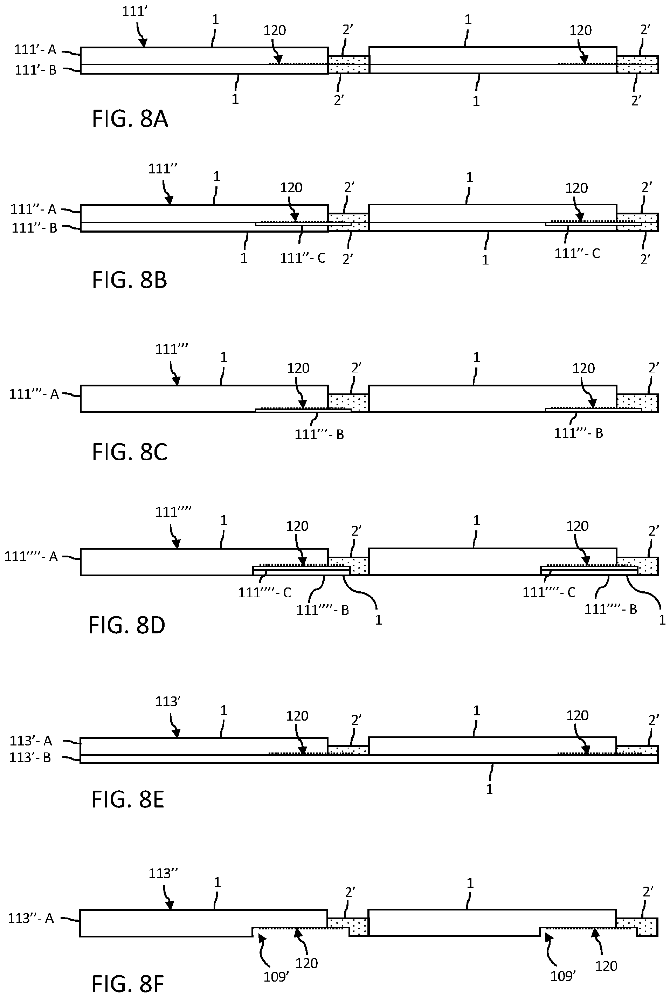

FIG. 8A shows schematically a cross section of a multilayered decking panel 111' like that shown in FIG. 6, after assembly.

FIG. 8B shows schematically a cross section of a multilayered decking panel 111" like that shown in FIG.7, after assembly.

FIG. 8C shows schematically a cross section of a multilayered decking panel 111‴ according to a different embodiment. In particular, the multilayered decking panel 111‴ comprises a top layer 111‴- A comprising the adjacent strips 1, 2' and a bottom layer 111‴- B made of the same material and shape as the intermediate layer 111" - C of FIG. 7 and FIG. 8B, e.g. a flexible polyimide film, and different from the materials of the top layer 111‴- A. In particular, the thermopiles 120 are printed directly on narrow and thin strips 111‴- B of this material and inserted into respective recesses on the bottom of the top layer 111‴- A and joined to the top layer 111‴- A as a bottom layer.

FIG. 8D shows schematically yet another embodiment of multilayered decking panel 111"", similar to that of FIG. 8C, with the difference that the bottom layer 111‴- B of FIG. 8C on which the thermopile 120 is printed is now an intermediate layer 111""- C arranged closer to the top surface of the top layer 111ʺʺ- A. An additional bottom layer 111ʺʺ- B of e.g. the same size as the intermediate layer 111ʺʺ- C and of e.g. the same material as the strip 1 with the lower thermal absorption property, is then used to seal the gap underneath the intermediate layer 111""- C.

FIG. 8E shows schematically yet another embodiment of multilayered decking panel 113', comprising a top layer 113'- A that is identical e.g. to the top layers 11 1'- A, 111"- A of FIG. 8A and FIG. 8B respectively, and a continuous bottom layer 113'- B that is made e.g. only of the same material as the strip 1 with the lower thermal absorption property and where the thermopiles 120 are printed directly on the top side of this bottom layer 113'- B before alignment and joining of the top layer 113'- A and bottom layer 113'- B.

FIG. 8F shows schematically yet another embodiment of decking panel 113" made as a single layer 113"- A where the thermopiles 120 are printed directly on a bottom side of the single layer 113"- A e.g. in recesses 109' of the bottom side of the single layer 113"- A.

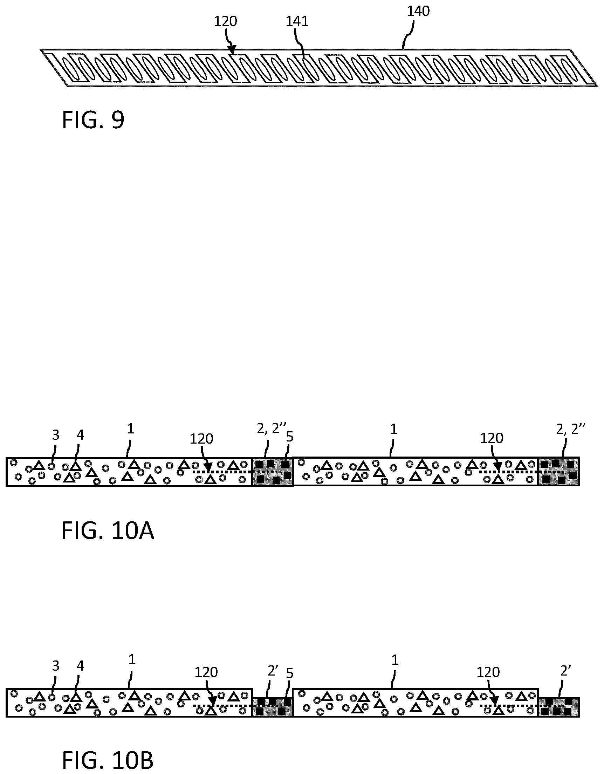

FIG. 9 shows schematically a possible layout of a flexible polyimide film 140 used e.g. as intermediate layer 111" - C (in FIG. 8B), 111ʺʺ- C (in FIG. 8D) or bottom layer 111‴- B (in FIG. 8C) of a multilayered decking panel 111", 111"", 111'", with a thermopile 120 printed thereon. In particular, the film 140 comprises cut-outs 141 that may facilitate integration of the strip 140 into the decking panel 111", 111"", e.g. upon welding of all layers together or upon fixing of the decking panel 111‴ to the marine vessel deck 210 by adhesive. The film 140 and the cut-outs 141 may have any other layout and extend e.g. up to the entire dimension of the decking panel 111", 111"", 111''', on which a plurality of, e.g. up to all, thermopiles 120 belonging to the same decking panel 111", 111"", 111‴ are printed and connected in series or in parallel as shown e.g. in FIG. 5A and FIG. 5B, as long as the printing layout is such that upon assembly and joining of all layers together the thermopiles 120 with their respective junctions are aligned and in thermal contact with the respective adjacent strips 1, 2', 2' of the decking panel 111", 111"", 111‴.

FIG. 10A schematically shows in cross section an embodiment like the embodiment A of FIG. 2, or like the embodiment of FIG. 3, with the adjacent strips 1, 2, 2" having the same thickness. In particular different possible ways are shown, that can be used in combination, for increasing the difference in thermal absorption properties between the adjacent strips 1, 2, 2" and hence for increasing the temperature difference between the adjacent strips 1, 2, 2" under the same conditions of solar radiation. In this example, the alternating adjacent strips 1, 2, 2" have first of all a respectively different color, e.g. the strips 1 have a white or lighter gray color contributing to the lower thermal absorption property, whereas the strips 2, 2" have a black or darker gray color contributing to the higher thermal absorption property. Moreover, the strips 1 with the lower thermal absorption property are made with a material composition comprising hollow microspheres 3 and heat reflective fillers 4 whereas the strips 2 with the higher thermal absorption property are made with a material composition comprising heat absorptive fillers 5.

FIG. 10B schematically shows nearly the same example as in FIG. 10A with a combination of methods to increase the temperature differential between the adjacent strips 1, 2', but with a layout corresponding to the embodiment B of FIG. 2, where the strips 2' with the higher thermal absorption property have a lower thickness and hence are deeper than the strips 1 with the lower thermal absorption property. As already discussed in connection with FIG. 2, an additional advantage of this embodiment is that the thermopiles 120 are closer to the top surface of the deeper strips 2' having relatively higher absorption property and farther from the top surface of the adjacent strips 1 having relatively lower thermal absorption property. Since thermal absorption is highest at the top surface and diminishes through the thickness of the decking panel, this results in an even higher temperature differential between the adjacent strips 1, 2' compared to the embodiment of FIG. 10A where the adjacent strips 1, 2, 2" are on the same level.

With continued reference to FIG. 1-4, FIG. 5A-5B, FIG. 6-7, FIG. 8A-8F, FIG. 9, FIG.10A-10B a method of manufacturing a synthetic decking for marine vessel decks 210 is also described. The method comprises manufacturing at least one decking panel 111, 112, 113, 111', 111", 111'", 111"", 113', 113" comprising extruding jointly at least two adjacent strips 1, 2, 2', 2" and/or welding together at least two extruded adjacent strips 1, 2, 2', 2" imitating planks 1 separated by caulking 2, 2' or planks 1, 2" directly adjacent to each other, and comprises using alternately different extrudable material compositions for the adjacent strips 1, 2, 2', 2" having respectively different thermal absorption properties such that strips 1 with a relatively lower thermal absorption property alternate to strips 2, 2', 2" with a relatively higher thermal absorption property, thereby resulting in a temperature difference between adjacent strips 1, 2, 2', 2" when the decking panel 111, 112, 113, 111', 111", 111‴, 111"", 113', 113" is exposed to solar radiation. The method further comprises integrating at least one thermopile 120 into the decking panel 111, 112, 113, 111', 111", 111‴, 111"", 113', 113"comprising a series of thermocouples 123 having junctions 121, 122 alternately arranged in thermal contact with either of the at least two adjacent strips 1, 2, 2', 2" such as to generate an output voltage and an electric current based on the thermoelectric Seebeck effect caused by the temperature difference between the adjacent strips 1, 2, 2', 2".

According to an embodiment, the method comprises using material compositions for the adjacent strips 1, 2, 2', 2" having respectively different colors, the color being substantially responsible for the respectively different thermal absorption property, and/or using a material composition for the strips 1 with the relatively lower thermal absorption property comprising hollow microspheres 3 and/or heat reflective fillers 4 and/or using a material composition for the strips 2, 2', 2" with the relatively higher thermal absorption property comprising heat absorptive fillers 5.

According to an embodiment, the method comprises manufacturing the strips 2, 2' with the relatively higher thermal absorption property with a width smaller than the strips 1 with the relatively lower thermal absorption property and/or arranging the strips 2' with the relatively higher thermal absorption property sufficiently deeper than the strips 1 with the relatively lower thermal absorption property such as to avoid contact with the deeper strips 2' upon walking on the synthetic decking 100.

According to an embodiment, integrating the at least one thermopile 120 into the decking panel 111, 112, 113, 111', 111", 111‴, 111ʺʺ, 113', 113" comprises manufacturing the decking panel 113" as a single layer 113"- A and printing the thermopile 120 directly on a bottom side of the single layer 113"- A or manufacturing the decking panel 111', 111", 111‴, 111ʺʺ, 113' as a multilayer comprising at least a top layer 111'- A, 111"- A, 111‴- A, 111""- A, 113'- A and a bottom layer 111'- B, 111"- B, 111'"- B, 111""- B, 113'- B, wherein the bottom layer 111'- B, 111"- B, 111"'- B, 111""- B, 113'- B is made of the same or different material(s) of the top layer 111'- A, 111"- A, 111'" '- A, 111""- A, 113'- A, and printing the thermopile 120 directly either on a bottom side of the top layer (not shown) or on a top side of the bottom layer 111'- B, 111"- B, 111"'- B, 111""- B, 113'- B or on an intermediate layer 111"- C, 111'"- C, of the same or different material(s) of the top layer 111'- A, 111"- A, 111‴- A, 111""- A, 113'- A and/or bottom layer 111'- B, 111"- B, 111‴- B, 111""- B, 113'- B and then sandwiching the intermediate layer 111"- C, 111‴- C between the top layer 111'- A, 111"- A, 111'"- A, 111""- A, 113'- A and the bottom layer 111'- B, 111"- B, 111‴- B, 111ʺʺ- B, 113'- B comprising aligning and joining all layers thereby embedding the thermopile 120 at least partly in the inside of the decking panel 111', 111", 111''', 111 "", 113' between the bottom layer 111'- B, 111"- B, 111"'- B, 111""- B, 113'- B and the top layer 111'- A, 111"- A, 111‴- A, 111""- A, 113'- A.

According to an embodiment, the method comprises printing the thermopile 120 by dispenser or inkjet printing or screen printing or any other suitable printing technique using respectively inks, screen printable pastes or mixes comprising thermoelectric materials mixed with a suitable binder and/or solvent.

According to an embodiment, the method comprises adding electrical connectors or terminals 131, 132 to the decking panel 111, 112, 113 for connecting the at least one thermopile 120 of a decking panel 111 to at least another thermopile of another decking panel 112, 113 and/or to an electric circuit 11 connected to an electrical energy receiving and/or storage unit 10.

In the preceding specification, numerous specific details have been described in order to provide a thorough understanding of the present disclosure. It will be apparent, however, to one having ordinary skill in the art that the specific details need not be employed to practice the present teaching. In other instances, well-known materials, parts, or methods have not been described in detail in order to avoid obscuring the present disclosure. Particularly, modifications and variations of the disclosed embodiments are certainly possible in light of the above description. It is therefore to be understood, that within the scope of the appended claims, the invention may be practiced otherwise than as specifically devised in the above examples.

Reference throughout the preceding specification to "one embodiment", "an embodiment", "one example" or "an example", means that a particular feature, structure or characteristic described in connection with the embodiment or example is included in at least one embodiment. Thus, appearances of the phrases "in one embodiment", "in an embodiment", "one example" or "an example", in various places throughout this specification are not necessarily all referring to the same embodiment or example. Furthermore, the particular features, structures, or characteristics may be combined in any suitable combinations and / or sub-combinations in one or more embodiments or examples.

## Claims

1. Synthetic decking (100) for marine vessel decks (210) comprising at least one decking panel (111, 112, 113, 111', 111", 111‴, 111ʺʺ, 113', 113") comprising at least two adjacent strips (1, 2, 2', 2") imitating planks (1) separated by caulking (2, 2') or planks (1, 2") directly adjacent to each other, the adjacent strips (1, 2, 2', 2") alternately having respectively different thermal absorption properties such that strips (1) with a relatively lower thermal absorption property alternate to strips (2, 2', 2") with a relatively higher thermal absorption property, thereby resulting in a temperature difference between adjacent strips (1, 2, 2', 2") when the decking panel is exposed to solar radiation,
the decking panel (111, 112, 113, 111', 111", 111‴, 111"", 113', 113") further comprising at least one integrated thermopile (120) comprising a series of thermocouples (123) having junctions (121, 122) alternately arranged in thermal contact with either of the at least two adjacent strips (1, 2, 2', 2") such as to generate an output voltage and an electric current based on the thermoelectric Seebeck effect caused by the temperature difference between the adjacent strips (1, 2, 2', 2").

2. The synthetic decking (100) according to claim 1 wherein the alternating adjacent strips (1, 2, 2', 2") have a respectively different color, the color being substantially responsible for the respectively different thermal absorption property and/or wherein the strips (1) with the lower thermal absorption property are made with a material composition comprising hollow microspheres (3) and/or heat reflective fillers (4) and/or wherein the strips (2, 2' 2") with the higher thermal absorption property are made with a material composition comprising heat absorptive fillers (5).

3. The synthetic decking (100) according to claim 1 or 2 wherein the strips (2, 2') with the relatively higher thermal absorption property have a width smaller than the strips (1) with the relatively lower thermal absorption property and/or wherein the strips (2') with the relatively higher thermal absorption property are arranged sufficiently deeper than the strips (1) with the relatively lower thermal absorption property such as to avoid contact with the deeper strips (2') upon walking on the synthetic decking (100).

4. The synthetic decking (100) according to any of the preceding claims wherein the adjacent strips (1, 2, 2', 2") are either extruded jointly together or welded together or a combination of both.

5. The synthetic decking (100) according to any of the preceding claims wherein the decking panel (113") is made as a single layer (113"- A) and the thermopile (120) is printed directly on a bottom side of the single layer (113"- A) or wherein the decking panel (111', 111", 111‴, 111"", 113') is made as a multilayer comprising at least a top layer (111'- A, 111"-A, 111‴- A, 111""- A, 113'- A) and a bottom layer (111'-B, 111"-B, 111"'-B, 111""- B, 113'- B), wherein the bottom layer (111'- B, 111"-B, 111‴- B, 111""- B, 113'- B ) is made of the same or different material(s) of the top layer (111'- A, 111"- A, 111‴- A, 111""- A, 113'- A ), and wherein the thermopile (120) is printed directly either on a bottom side of the top layer or on a top side of the bottom layer (111'- B, 111"- B, 111‴- B, 111""- B, 113'- B ) or on an intermediate layer (111"- C, 111‴- C ) of the same or different material(s) of the top layer(111'- A, 111"-A, 111"'-A, 111""- A, 113'- A) and/or bottom layer (111'- B, 111"- B, 111'"- B, 111""- B, 113'- B ) and then sandwiched between the top layer (111'- A, 111"- A, 111'"- A, 111""- A, 113'- A ) and the bottom layer (111'- B, 111"- B, 111‴- B, 111ʺʺ- B, 113'- B ) comprising alignment and joining of all layers such that the thermopile (120) is embedded at least partly in the inside of the decking panel (111', 111", 111‴, 111"", 113') between the bottom layer (111'- B, 111"- B, 111‴- B, 111""-B, 113'-B) and the top layer (111'- A, 111"-A, 111‴- A, 111""-A, 113'-A).

6. The synthetic decking (100) according to claim 5 wherein the different material for the bottom layer (111‴- B) or the intermediate layer (111"- C, 111‴- C) is a flexible polyimide film.

7. The synthetic decking (100) according to claim 5 or 6 wherein the thermopile (120) is printed by dispenser or inkjet printing or screen printing or any other suitable printing technique using respectively inks, screen printable pastes or mixes comprising thermoelectric materials mixed with a suitable binder and/or solvent.

8. The synthetic decking (100) according to any of the preceding claims wherein the decking panel (111, 112, 113) comprises electrical connectors or terminals (131, 132) for connecting the at least one thermopile (120) of a decking panel (111) to at least another thermopile (120) of another decking panel (112, 113) and/or to an electric circuit (11) connected to an electrical energy receiving and/or storage unit (10).

9. A marine vessel (200) comprising a synthetic decking (100) according to any of the claims 1 to 8 and an electrical energy receiving and/or storage unit (10) connected to the synthetic decking (100) via an electric circuit (11).

10. A method of manufacturing a synthetic decking (100) for marine vessel decks (210) comprising manufacturing at least one decking panel (111, 112, 113, 111', 111", 111‴, 111ʺʺ, 113', 113" ) comprising extruding jointly at least two adjacent strips (1, 2, 2', 2") and/or welding together at least two extruded adjacent strips (1, 2, 2', 2") imitating planks (1) separated by caulking (2, 2') or planks (1, 2") directly adjacent to each other, the method comprising using alternately different extrudable material compositions for the adjacent strips (1, 2, 2', 2") having respectively different thermal absorption properties such that strips (1) with a relatively lower thermal absorption property alternate to strips (2, 2', 2") with a relatively higher thermal absorption property, thereby resulting in a temperature difference between adjacent strips (1, 2, 2', 2") when the decking panel (111, 112, 113, 111', 111", 111‴, 111ʺʺ, 113', 113" ) is exposed to solar radiation,
the method further comprising integrating at least one thermopile (120) into the decking panel (111, 112, 113, 111', 111", 111'", 111"", 113', 113" ) comprising a series of thermocouples (123) having junctions (121, 122) alternately arranged in thermal contact with either of the at least two adjacent strips (1, 2, 2', 2") such as to generate an output voltage and an electric current based on the thermoelectric Seebeck effect caused by the temperature difference between the adjacent strips (1, 2, 2', 2").

11. The method according to claim 10 comprising using material compositions for the adjacent strips (1, 2, 2', 2") having respectively different colors, the color being substantially responsible for the respectively different thermal absorption property, and/or using a material composition for the strips (1) with the relatively lower thermal absorption property comprising hollow microspheres (3) and/or heat reflective fillers (4) and/or using a material composition for the strips (2, 2', 2") with the relatively higher thermal absorption property comprising heat absorptive fillers (5).

12. The method according to claim 10 or 11 comprising manufacturing the strips (2, 2') with the relatively higher thermal absorption property with a width smaller than the strips (1) with the relatively lower thermal absorption property and/or arranging the strips (2') with the relatively higher thermal absorption property sufficiently deeper than the strips (1) with the relatively lower thermal absorption property such as to avoid contact with the deeper strips (2') upon walking on the synthetic decking (100).

13. The method according to any of the claims 10 to 12 wherein integrating the at least one thermopile (120) into the decking panel (111, 112, 113, 111', 111", 111‴, 111ʺʺ, 113', 113") comprises manufacturing the decking panel (113") as a single layer (113"-A) and printing the thermopile (120) directly on a bottom side of the single layer (113"-A) or manufacturing the decking panel (111', 111", 111'", 111"", 113') as a multilayer comprising at least a top layer (111'- A, 111"- A, 111‴- A, 111""- A, 113'- A ) and a bottom layer (111'- B, 111"- B, 111'"- B, 111""- B, 113'- B ), wherein the bottom layer (111'- B, 111"- B, 111‴- B, 111""- B, 113'- B ) is made of the same or different material(s) of the top layer (111'- A, 111"- A, 111‴- A, 111ʺʺ- A, 113'- A), and printing the thermopile (120) directly either on a bottom side of the top layer or on a top side of the bottom layer (111'- B, 111"- B, 111‴- B, 111ʺʺ- B, 113'- B ) or on an intermediate layer of the same or different material(s) of the top layer (111'- A, 111"- A, 111'"- A, 111""- A, 113'- A ) and/or bottom layer (111'- B, 111"- B, 111'"- B, 111""- B, 113'- B ) and then sandwiching the intermediate layer between the top layer (111'- A, 111"- A, 111'"- A, 111""- A, 113'-A) and the bottom layer (111'- B, 111"- B, 111‴- B, 111""-B, 113'- B ) comprising aligning and joining all layers thereby embedding the thermopile at least partly in the inside of the decking panel between the bottom layer (111'- B, 111"- B, 111‴- B, 111""-B, 113'- B ) and the top layer (111'- A, 111"- A, 111‴-A, 111""-A, 113'-A ).

14. The method according to claim 13 comprising printing the thermopile (120) by dispenser or inkjet printing or screen printing or any other suitable printing technique using respectively inks, screen printable pastes or mixes comprising thermoelectric materials mixed with a suitable binder and/or solvent.

15. The method according to any of the claims 10 to 14 comprising adding electrical connectors or terminals (131, 132) to the decking panel (111, 112, 113) for connecting the at least one thermopile (120) of a decking panel (111) to at least another thermopile (120) of another decking panel (111, 113) and/or to an electric circuit (11) connected to an electrical energy receiving and/or storage unit (10).
